# EUROPEAN PATENT SPECIFICATION

(11) **EP 0 896 363 B1**
(45) Date of publication and mention of the grant of the patent: **13.10.2004**
(21) Application number: 98306385.0
(22) Date of filing: 10.08.1998
(51) Int. Cl.: H01L 21/00, H05K 13/00, H05K 13/06, H01L 21/60

(54) **Spool case of bonding wire**
Bonddrahtspindelbehälter
Boitier pour bobine de fil de connexion

(30) Priority: 08.08.1997 JP 21478397
(43) Date of publication of application: 10.02.1999
(73) Proprietor: TANAKA DENSHI KOGYO KABUSHIKI KAISHA, Chuo-ku, Tokyo (JP)
(72) Inventor: Anjo, Tadao, c/o Tanaka Denshi Kogyo K.K., Mitaka-shi, Tokyo (JP); Sato, Osamu, c/o Tanaka Denshi Kogyo K.K., Mitaka-shi, Tokyo (JP); Kaji, Toshio, c/o Tanaka Denshi Kogyo K.K., Mitaka-shi, Tokyo (JP); Nishimura, Keiichi, c/o Tanaka Denshi Kogyo K.K., Mitaka-shi, Tokyo (JP)
(74) Representative: Wood, Graham

(56) References cited:
- PATENT ABSTRACTS OF JAPAN vol. 1997, no. 10, 31 October 1997 (1997-10-31) & JP 09 153510 A (NITTETSU MICRO METAL), 10 June 1997 (1997-06-10)
- PATENT ABSTRACTS OF JAPAN vol. 1999, no. 3, 31 March 1999 (1999-03-31) & JP 10 326804 A (MITSUBISHI MATERIALS CORP), 8 December 1998 (1998-12-08)
- PATENT ABSTRACTS OF JAPAN vol. 1995, no. 9, 31 October 1995 (1995-10-31) & JP 07 161754 A (MITSUBISHI MATERIALS CORP), 23 June 1995 (1995-06-23)
- PATENT ABSTRACTS OF JAPAN vol. 1995, no. 6, 31 July 1995 (1995-07-31) & JP 07 086326 A (SUMITOMO METAL MINING CO LTD), 31 March 1995 (1995-03-31)

## Description

### 1. BACKGROUND OF THE INVENTION:

### FIELD OF THE INVENTION

This invention relates to a spool case for a bonding wire for a semi-conductor, and more particularly a spool case in which the spool can be handled without being contacted with the bonding wire wound around the spool barrel section.

### DESCRIPTION OF THE PRIOR ART

In the prior art, various kinds of structures have been known as a case in which the spool having the bonding wire wound therearound used in an assembling of a semi-conductor device is stored in it.

For example, the Japanese Utility Model Publication No. Sho 58-41188 discloses a spool case in which the case is comprised of a base having an upward expanded fitting ridge having the spool integrally fitted therein and a cover fitted to the outer circumferential ridge of the base, the cover is formed with a pressing concave section fitted to the spool in correspondence with the fitting ridge, the stored spool is pushed by the fitting ridge and the cover to prevent a looseness of.

In view of the fact, the spool stored in this kind of spool case was installed at the spool holder of the wire bonding device after being taken out at an assembling site of the semi-conductor device, although in the prior art, the flange of the spool in the prior art was held by hand, the hand was contacted with the surface of the wire, thereby there was a possibility that the wire damage was produced.

In order to eliminate the disadvantages, the Japanese Patent Laid-Open No. Hei 7-86326 discloses a spool case for a bonding wire in which the spool case is comprised of a base and a cover to be fitted to each other and at least one of the base and the cover is provided with the spool holding section capable of holding the spool and engaging or disengaging the spool without making any direct contact with hand to the spool.

### 2. SUMMARY OF THE INVENTION:

However, detailed studying of the prior art spool case described in the aforesaid official gazettes of laid-open patent and utility model showed the following problems.

That is, in reference to the detailed description of the invention, the spool holding section of the spool case is constructed such that an inside part of a loaded wall contacted with the inner wall of the barrel section of the spool is provided with a concave section acting as an operating section for resiliently deforming the loaded wall, a finger inserted into the concave portion is opened outwardly or closed inwardly to cause the loaded wall to be resiliently deformed to adjust a contact pressure of the loaded wall against the inner wall of the barrel section.

In turn, the spool is loaded at the spool holder of the wire bonding device while being fitted from outside, although there are various kinds of lengths of the spool holder in reference to the bonding device, and in recent years, various kinds of spool holders having spool engaging means are proposed to accommodate for an increased weight of total spool as the length of the wire to be wound on the spool is elongated, wherein the engaging means is arranged at the spool holder so as to be contacted with the inner wall of the barrel section of the spool.

Accordingly, in the case that the prior art spool case having the loaded wall contacted with the inner wall of the barrel section of the spool to hold the spool, the spool holding section was struck against the extremity end of the spool holder or the spool engaging means to cause a certain trouble to be found in the installation of the spool.

In addition, the prior art spool case is constructed such that a contact pressure of the spool holding section is adjusted under an opening section or closing operation of the finger inserted into the concave section as described above, an erroneous operation of the finger is performed under a mistake of the operator causes the contacted state to be released and the spool is dropped.

The present invention has been invented in reference to the aforesaid circumstances in the prior art and its object consists in providing a new spool case in which the spool stored in the case can be held without contacting with the spool by hand, engaging or disengaging of the spool in respect to the bonding device can be carried out without having any relation with a length of the spool holder or presence or non-presence of the spool engaging means, a high reliability in holding of the spool can be attained, the spool holding state can be easily maintained.

In order to attain the aforesaid object, the present invention provides a spool case according to claim 1, of the base and the cover to be fitted to each other and is as well as a spool case incombination with a spool stored therein according to claim 7 and a method for handling a spool using the spool case according to claim 9.

In the case that the spool case is constructed as defined in claim 1, the spool can be held by the base or the cover by the engaging pieces arranged in at least one of the base or the cover and the spool can be handled without making a direct contact of the spool. This held state is not released so long as it may not be released by deforming the engaging pieces. In addition, the held state is carried out such that the engaging pieces are engaged with the outer circumferential edge of the flange and held, and it is apparent that no interference is produced at either the wire wound around the spool barrel section or inside part of the spool barrel section.

The aforesaid engaging pieces are preferably of resilient material. In this case, although the engaging pieces are formed in such a way that they may be resiliently engaged with the flange, for example, it is also possible that either synthetic resin material having an appropriate resiliency or metallic material having spring characteristic such as a stainless steel or copper alloy or the like is applied to form a substantial leaf spring shape, a substantial claw shape and a substantial hook shape under wall thickness and size enabling an easy resilient deformation.

The engaging pieces are arranged such that they may be removably engaged with the outer circumferential edge of the flange of the spool. A plurality of the engaging pieces more than two are preferably arranged and more preferably a plurality of more than three engaging pieces are arranged. In addition, the engaging pieces can be formed into a continuous shape without being divided into a plurality of divided sections, resulting in that it can also be applied as the deformable structure.

It may be assumed that the engaging pieces are placed at at least either the base or the cover. Additional engaging pieces may be arranged at the outside part of the base.

Thus, engaging pieces can be arranged at the base, the plurality of engaging pieces having the substantial claw shape or the substantial hook shape being arranged at proper spacings along the outer circumferential edge of the flange at at least one of the inner surface of the base abutted against the outer surface of the flange of the stored spool or the outer surface of the base acting as a rear side of the inner surface.

In the case that the pieces are arranged at the cover, it can be illustrated that a plurality of engaging pieces of substantial leaf spring shape are properly spaced apart along the outer circumferential edge of the flange of the stored spool at the inner circumferential surface of the cover.

It is possible to store the spool in the spool case under a state in which the spool is held at the base or the cover, and after opening section the case, the base or the cover holding the spool is handled to enable the spool to be handled without making any direct contact with hand to the spool.

In the case that engaging pieces are arranged at the outer surface of the base, the base is turned over after opening section the case under a state in which the spool is stored in the cover, and the engaging pieces at the outside part of the base are resiliently engaged with the flange to cause the spool to be held at the base, the base is handled to enable the spool to be handled without making any direct contact to the spool by hand.

In addition, the engaging pieces can be separately and resiliently deformed from the base and the cover, resulting in that the engaging pieces are resiliently deformed by themselves to enable the engaging or disengaging with the flange to be carried out.

However, in this case, since an increased number of engaging pieces causes the operation to be troublesome, the base or the cover having the engaging pieces is moulded in such a way that it may be resiliently deformed, the engaging pieces are integrally formed at the base or the cover, the engaging pieces are integrally and resiliently deformed with the base or the cover to enable the spool to be engaged or disengaged.

In the case that the stored spool can be held under a state in which its central axis is held at a lateral substantial horizontal orientation, load of the wire, vibration during handling or transportation or the like and shock are dispersed in a substantial uniform manner over an entire length of the wire wound around the spool and then a collapsed wound state of the wire can be effectively prevented.

As means for holding it with the central axis of the spool being held under a state in which it is kept at a lateral orientation of a substantial horizontal direction, the lower end surface of the base is made flat or the mounting means capable of holding the horizontal state can be arranged.

The bonding wire wound around the spool is applied while its both ends are adhered to the flange section of the spool by a tape or the like. In the case that the wire is adhered to the outside section of the aforesaid flange, it is applied while the flange section is provided with a notch for use in passing the wire in it. The notch can be used while it is being fixed to either one side or both sides of the spool.

Both end flanges of the spool for winding the bonding wire are applied in the prior art in a diameter of 58.5 mm in this kind of technical field. In spool case of the present invention, a large diameter application is more effective and the diameter of 58,5 to 80 mm is preferably applied. In addition, it is also possible that only one side of large diameter is applied in view of the structure in an automatic bonding machine provided with the spool. In this case, it is preferable that the flange diameter is in a range of 58.5 to 80 mm.

It is preferable that the base is made such that a plurality of engaging sections resiliently engaged with the outer circumferential edge of the flange of the spool stored in the spool case are arranged at an inner surface of the outer circumferential ridge fitted to the cover, each of the engaging sections is integrally and resiliently deformed with the base so as to removably hold the spool, and at the same time the cover is provided with an expanded guiding ridge for loading it into the barrel section of the spool, the guiding ridge is formed to cause the spool to be guided when the spool case is opened or closed.

As a practical configuration of the guiding ridge, it is preferable to form it in a range that a length of the guiding ridge is 1/2 or more of a horizontal length (L) of the cover and projected only by 1/2 (L) from the opening section edge of the cover.

In addition, the base in the present invention is not limited to one acting as a container storing the spool, but the cover is not limited to one acting as a lid for closing the container, it may include the case in which the cover may act as the container and the base acts as the lid. In brief, if the spool can be stored in the spool case which is formed by the base and the cover fitted to each other, either the base or the cover may act as the container or the lid.

### 3. BRIEF DESCRIPTION OF THE DRAWINGS

Figs. 1 to 4 show an example I of a preferred embodiment, and wherein
Fig. 1 is a perspective view for showing one example of the preferred embodiment.
Fig. 2 is a sectional view taken along a line (A)-(A) of Fig. 1.
Fig. 3 is a sectional view taken along a line (B)-(B) of Fig. 2.
Fig. 4 is a sectional view for showing a state of use.
Figs. 5 to 10 show an example II of a preferred embodiment, and wherein

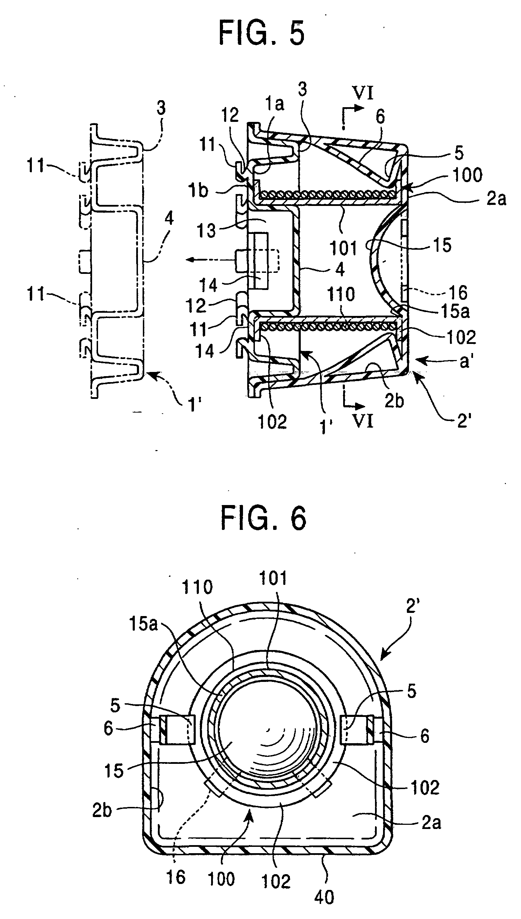

Fig. 5 is a longitudinal sectional view for showing one example of the preferred embodiment.
Fig. 6 is a sectional view taken along a line (C)-(C) of Fig. 5.

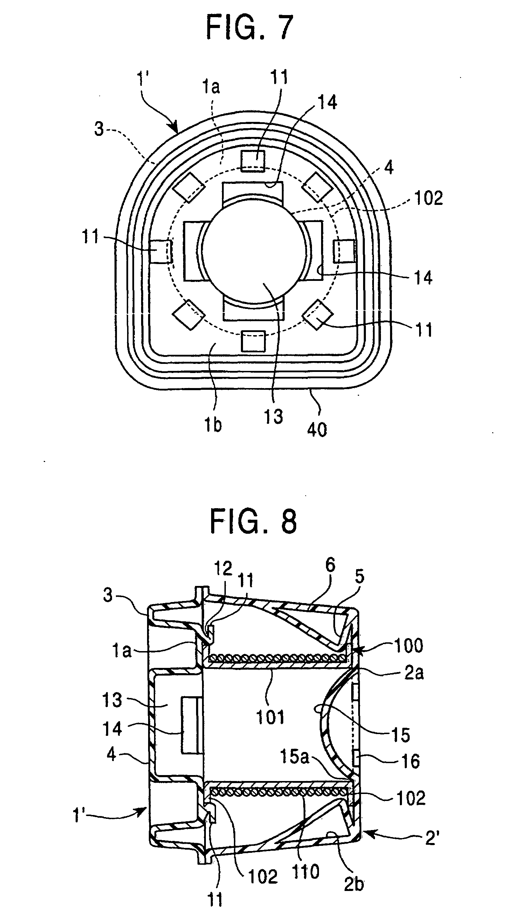

Fig. 7 is a top plan view for showing a base.
Fig. 8 is a longitudinal sectional view for showing a state of use.

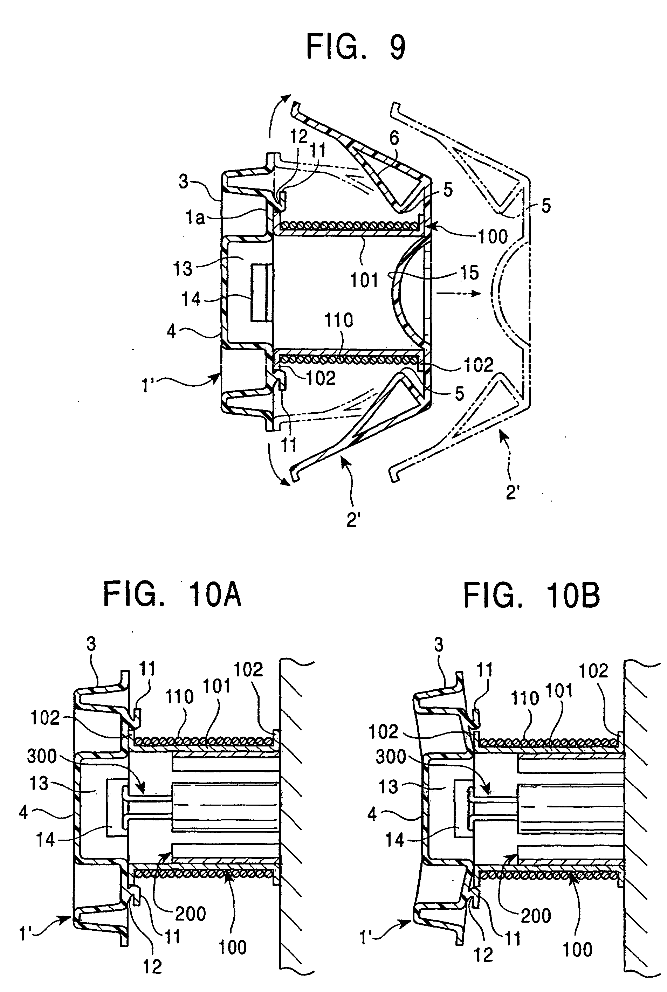

Fig. 9 is a longitudinal sectional view for showing a state of use.
Fig. 10 is a longitudinal sectional view for showing a state of use.

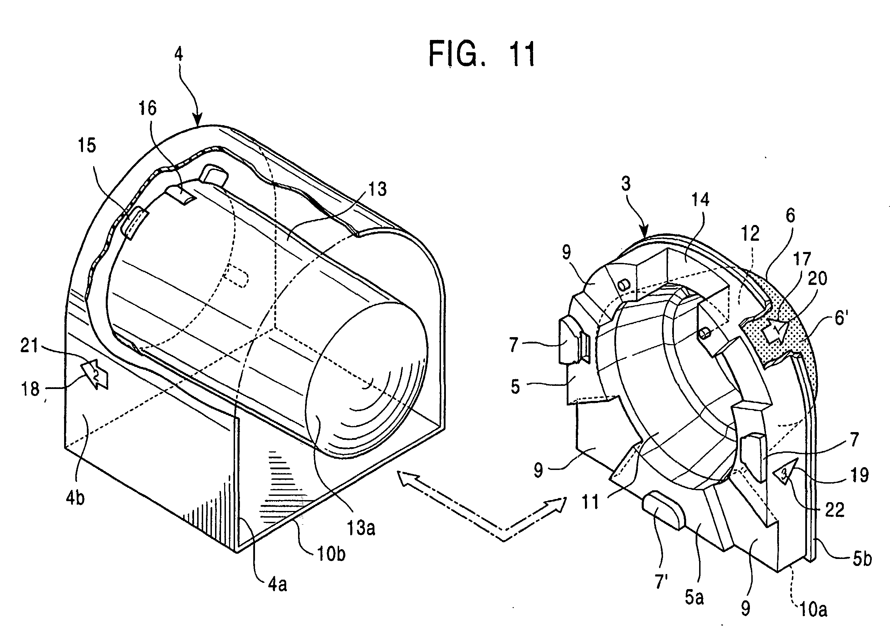

Figs. 11 to 17 show an example III of a preferred embodiment, wherein
Fig. 11 is an exploded perspective view for showing an example of the preferred embodiment.

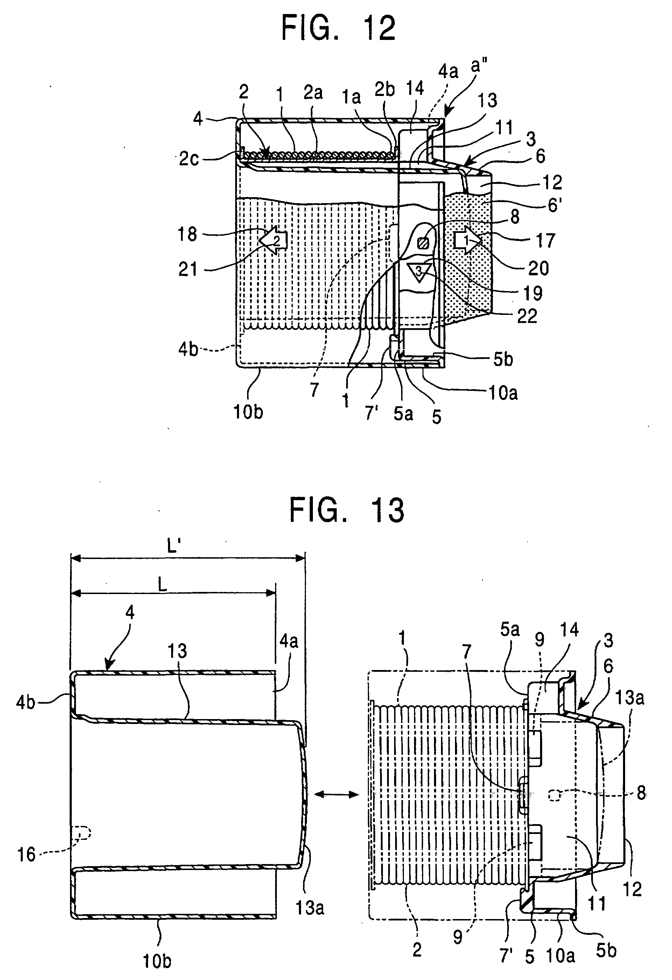

Fig. 12 is a front elevational view with a part being broken away to show a state of use.
Fig. 13 is an exploded longitudinal sectional view.

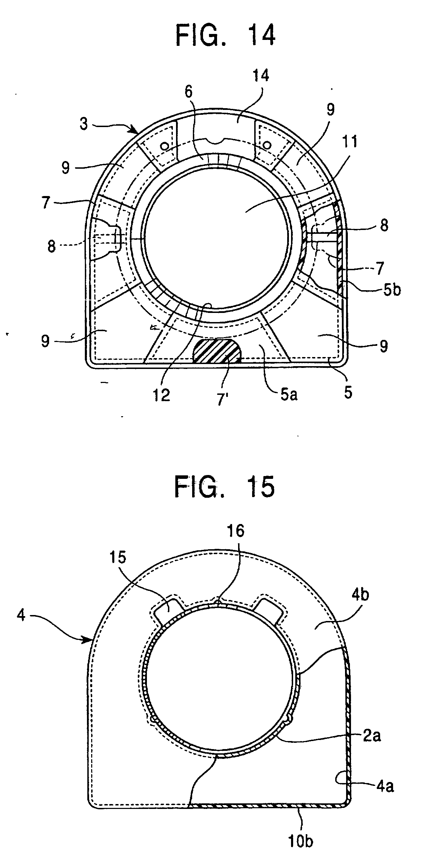

Fig. 14 is a top plan view for showing a base with a part being broken away.
Fig. 15 is a top plan view for showing a cover with a part being broken away.

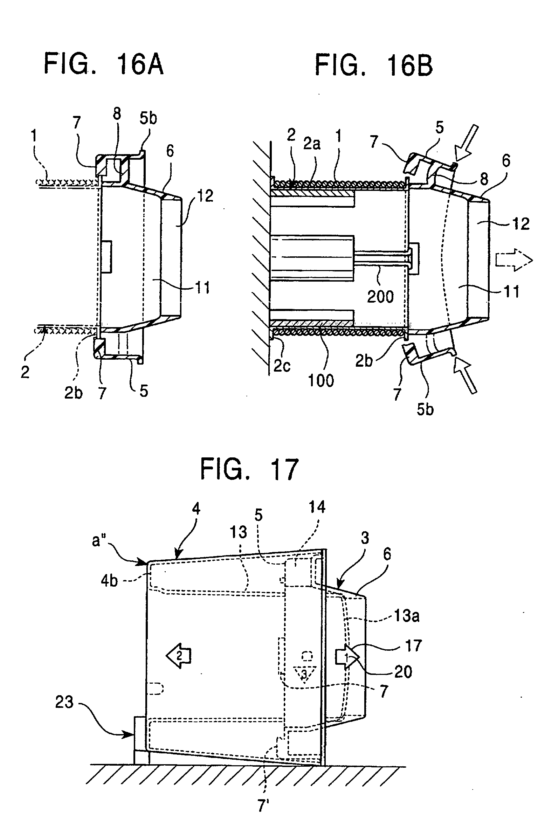

Fig. 16 is a longitudinal sectional view for showing a state of use.
Fig. 17 is a front elevational view for showing an example of the preferred embodiment.

### 4. DESCRIPTION OF THE PREFERRED EMBODIMENTS:

Referring now to the drawings, some preferred embodiments of the present invention will be described as follows.

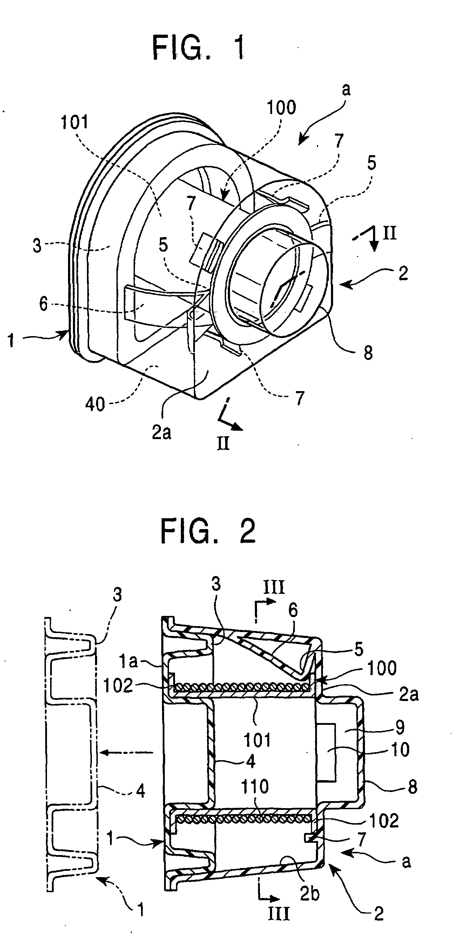

### [Example I of the preferred embodiment: Figs. 1 to 4]

In Figs. 1 to 4, (a) denotes a spool case, 100 denotes a spool, 110 denotes a bonding wire, 200 denotes a spool holder of a bonding device and 300 denotes a spool engaging means installed at the holder.

The spool 100 is of a structure which is usually used in this field of technology, wherein the spool 100 is comprised of a cylindrical barrel section 101 around which the bonding wire 110 is wound, and lateral flanges 102, 102 arranged at both end opening section edges of the spool 100.

The spool case (a) is comprised of the base 1 and the cover 2 which are fitted to each other, wherein the base 1 and the cover 2 are made of plastic material or the like, they are molded by a vacuum molding process or the like, they are integrally molded in such a way that they may be resiliently deformed, the spool 100 around which the bonding wire 110 is wound is stored within the base 1, and the cover 2 is applied to cover it.

The base 1 has an outer circumferential ridge 3 fitted to the cover 2 at its outer circumferential edge and the central part of the side wall section 1a is formed with a projecting expanded guiding ridge 4 fitted inside the barrel section 101 of the spool 100 so as to guide the spool 100.

The guiding ridge 4 is of a flat circular shape having a substantial same diameter as or slight smaller diameter than an inner diameter of the barrel section 101 and a gradual cone shape having a slight fine taper, and formed in such a way that the base end of the guiding ridge 4 may be fitted to the barrel section 101. In addition, a projecting size of the guiding ridge 4 is substantially the same as a size of the outer circumferential ridge 3 and about 2/3 of a length of the spool 100.

The cover 2 is fitted to the outer circumferential ridge 3 of the base 1 so as to prevent the spool 100 from being loosed, wherein its depth is formed to be substantially the same length of the spool 100 and one flange 102 of the spool 100 is abutted against the side wall section 2a.

The inner circumferential surface 2b of the cover 2 is formed with a pair of engaging pieces 5, 5 for use in holding the flange 102 while being resiliently engaged with opposing two locations at the outer circumferential edge of one flange 102.

These engaging pieces 5 are arranged at opposing two locations of the circumferential wall of the cover 2, form a substantial leaf spring with the side wall section 2a at the fixing section 6 being bent back to form a mountain shape, hold the flange 102 together with the side wall section 2a and then the cover 2 holds the spool 100.

In addition, these engaging pieces 5 are formed to be integrally continuous with the cover 2 and formed to enable engagement or disengagement in respect to the flange 102 (that is, fixing or removing of the spool 100) to be carried out as both engaging pieces 5, 5 are resiliently deformed in an integral manner with the cover 2.

In this example, although the engaging pieces 5 are arranged at the aforesaid two locations, the number of engaging pieces 5 is not limited to this number, the engaging pieces can be arranged at a plurality of appropriate locations where the spool 100 can be held and its engaging or disengaging can be easily carried out.

The side wall section 2a of the cover 2 is provided with a plurality of stoppers 7. The stoppers 7 are comprised of some raised pieces raised at the inner sides of the predetermined locations which are abutted to and engaged with a plurality of appropriate locations at the outer circumferential edge of the flange 102 so as to prevent the spool 100 held by the cover 2 from being loosened.

In addition, the central part of the side wall section 2a of the cover 2 is formed integrally with a cylindrical holding section 8 in an outward expanded state. The holding section 8 may act as a holding means when the cover 2 is handled and at the same time a concave section 9 inside the holding / c section 8 is corresponded to an inner side of the barrel section 101 of the spool 100 and also act as a relief section for an engaging means 300 arranged at the holder 200. 10 denotes a window hole arranged at a circumferential wall of the holding section 8, and the window hole 10 may also act as a relief section for the engaging means 300.

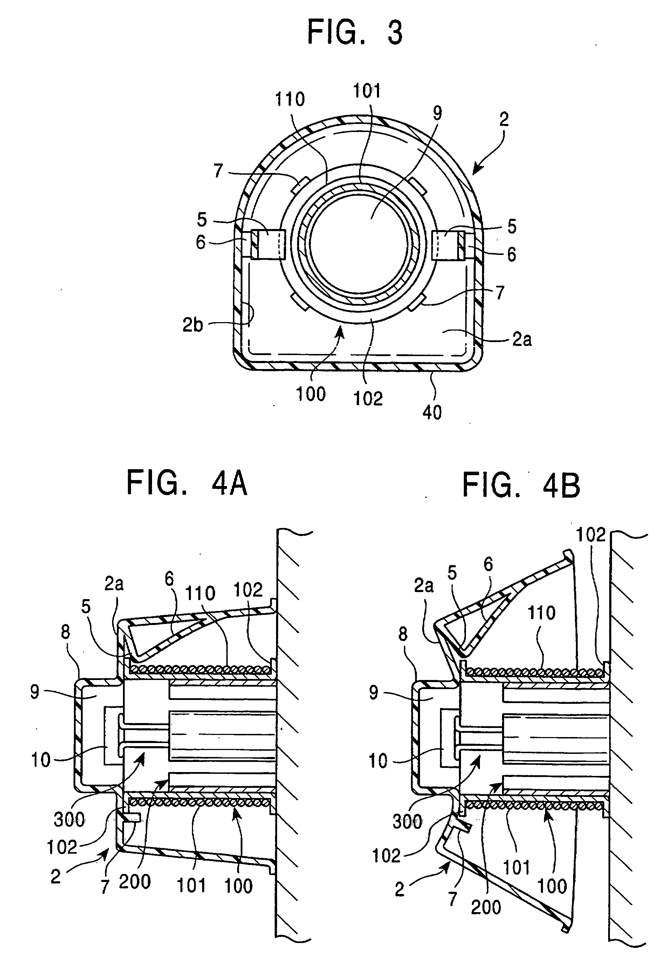

As shown in Figs. 1 and 3, the aforesaid outer circumferential ridge 3 and the circumferential wall of the cover 2 are formed as a substantial semi-cylindrical shape, its partial section is formed as a flat surface, and the flat surface may act as a mounting plane (a mounting means) 40 when the spool case (a) storing the spool 100 therein is placed on a working table or the like. That is, a wire is wound in a substantial equal manner against an axial direction, it is preferable to handle the spool 100 in such a manner as it may be faced laterally (such that the flanges 102, 102 are positioned laterally) so as to keep its state. If the spool case (a) is placed on the table or the like in such a way that the mounting surface, the handling described above can be carried out and at the same time it is possible to prevent the spool case (a) from being rolled.

In accordance with the spool case (a) of the present example constructed as described above, the spool 100 can be stored under a state in which the spool 100 is held at the cover 2, and after the base 1 and the cover 2 are separated from each other to open the case (a), the cover 2 held by the spool 100 is handled to enable the spool 100 to be handled without making any direct contact of hand with the spool 100.

The aforesaid held state is maintained by the resilient engaging force of the engaging pieces 5, 5 and this state may not be released so long as these engaging pieces 5, 5 are not resiliently deformed and not released from the flange 102. In addition, the aforesaid held state may act to cause each of the engaging pieces 5, 5 to be engaged with the outer circumferential edge of the flange 102 and held, and there is no interference for the wire 110 wound around the spool barrel section 101 or inside the barrel section 101.

For example, in the case that the spool 100 is installed at the spool holder 200 of the wire bonding device, the holding section 8 is held by a hand to cause the cover 2 to be covered on the holder 200, the spool 100 is outwardly fitted to the holder 200 (refer to Fig. 4(a)), then if the cover 2 is resiliently deformed, the engaging pieces 5, 5 are also integrally deformed to release the engagement with the flange 102 (refer to Fig. 4(b)), and after this operation, if only the cover 2 is released, the spool 100 is installed in the holder 200.

In addition, under the state shown in Fig. 4(a), it is possible to release the spool engaging means 300 arranged at the holder 200 into the concave section 9 or into the window hole 10, resulting in that the engaging means 300 does not hinder a spool installing work.

When the spool 100 is released from the holder 200, it is satisfactory that the aforesaid work is performed in a reverse order (Fig. 4(b) to (a)) to hold the spool 100 with the cover 2.

### [Example II of the preferred embodiment: Figs. 5 to 10]

A spool case (a') shown in Figs. 5 to 10 is comprised of a base 1' and a cover 2' mutually fitted to each other, wherein the base 1' and the cover 2' are, at their almost portions, constructed in the same manner as that of the aforesaid base 1 and the cover 2, although it is characterized in that the spool 100 held in the cover 2' is replaced in the base 1' so as to handle the spool 100.

The composing sections which are common to those described in the example I are denoted by the same reference numerals as those in the example I in the drawings, their overlapping description will be eliminated and only their different points will be described as follows.

The base 1' is provided with a plurality of engaging pieces 11 at a surface (that is, the outer surface) 1b corresponding to the outside part of the case at the side wall section 1a, the engaging pieces are resiliently engaged with a plurality of proper locations at an outer circumferential edge of the flange 102 to hold the flange 102.

These engaging pieces 11 are formed such that they are fixed to a plurality of appropriate locations at the outer surface 1b of the base 1', the extremity ends at the fixing sections 12 are bent back into a substantial claw-like shape or a substantial hook-like shape, thereby they correspond to appropriate spacings along the outer circumferential edge of the flange 102, and as shown in Fig. 8, under a state in which the base 1' is turned over (upside down), the flange 102 is held together with the outer surface 1b so as to hold the spool 100 at the base 1'.

In addition, these engaging pieces 11 are formed integrally with the base 1', more particularly the outer circumferential ridge 3, thereby as each of the engaging pieces 11 is resiliently deformed in integral with the outer circumferential ridge 3, the engaging or disengaging against the flange 102 (that is, fixing or removing of the spool 100) can be carried out.

Although the engaging pieces 11 are equally spaced apart to correspond to eight locations along the outer circumferential edge of the flange 102 in this example, the number of engaging pieces 11 is not restricted to this number, and they may be arranged at a plurality of appropriate locations where the spool 100 can be held and its fixing or removing can be carried out.

In addition, the guiding ridge 4 in this example may act as a handle member to handle the base 1' and at the same time the concave section 13 inside the guiding ridge 4 is corresponded to the inside part of the barrel section 101 of the spool 100 to act a releasing section for the engaging means 300 arranged at the holder 200. 14 denotes a window hole opened from the side wall section 1a over the circumferential wall of the guiding ridge 4, wherein the window hole 14 may also act as a releasing section for the engaging means 300.

Although the cover 2' is provided with a pair of aforesaid engaging pieces 5, 5, but is not provided with the stopper 7, holding section 8, concave section 9 and window hole 10, and the side wall section 2a is provided with a pressing concave section 15.

The pressing concave section 15 corresponds to the guiding ridge 4, coincides with and fits to the inside part of the barrel section 101 of the spool 100, and this is formed such that it may be projected in a substantial semi-spherical form with the central part of the side wall section 2a being faced inside. In addition, the pressing concave section 15 is formed to have such a diameter as one in which it may abut at an outer edge section 15a against an outer end of the inner circumference of the barrel section 101.

The side wall section 2a of the cover 2' is provided with a plurality of projections 16 which are positioned outside the outer edge section 15a and projected inwardly in proper spacings.

The projections 16 are formed to have such a depth as one in which their projecting end surfaces are abutted and engaged with the outer surface of the flange 102 so as to prevent an axial looseness of the spool 100.

In accordance with the spool case a' in the example constructed as described above, the spool 100 is held by the guiding ridge 4 and the pressing concave section 15 and at the same time the spool 100 can be stored under a state in which a pair of engaging pieces 5, 5 are resiliently engaged with one flange 102 to hold the spool 100 at the cover 2'. After the base 1' and the cover 2' are separated to open the case a', the spool 100 can be handled without performing a direct contact with the spool 100 by hand by handling the cover 2' in which the spool 100 is held.

In addition, as shown in Fig. 8, if the base 1' is turned back (upside down) to cause each of the engaging pieces 11 to be resiliently engaged with the other flange 102 of the spool 100 and thereafter the engaged state of the engaging pieces 5, 5 is released, the spool 100 is held at the base 1' and the spool 100 can be handled without performing a direct contact with the spool 100 by hand by handling the base 1' (refer to Figs. 8 and 9).

The held state is maintained by a resilient engaging force of each of the engaging pieces 11 and this is not released so long as these engaging pieces 11 are not resiliently deformed and not released from the flange 102. In addition, the held state causes each of the engaging pieces 11 to be engaged with the outer circumferential edge of the flange 102 and held, resulting in that no interference is produced against the wire 110 wound around the spool barrel section 101 or inside the barrel section 101.

For example, in the case that the spool 100 is installed at the spool holder 200, the outer circumferential ridge 3 is held by hand to cause the base 1' to be covered on the holder 200, wherein the spool 100 is outwardly fitted to the holder 200 (refer to Fig. 10(a)), then each of the engaging pieces 11 is integrally and resiliently deformed to cause the outer circumferential ridge 3 to be resiliently deformed in an outward direction (refer to Fig. 10(b)), thereafter if only the base 1' is released, the spool 100 is installed at the holder 200.

In addition, under the state shown in Fig. 10, it is possible to release the spool engaging means 300 arranged at the holder 200 into the concave section 13 or into the window hole 14, resulting in that the engaging means 300 does not become an inteference in the spool installing operation.

When the spool 100 is removed from the holder 200, it is satisfactory that the aforesaid work is performed in a reverse order (Figs. 10(b) to (a)) to cause the spool 100 to be held at the base 1'.

### [Example III in the preferred embodiment: Figs. 11 to 17]

The spool case a" shown in Figs. 11 to 17 is comprised of a base 3 and a cover 4 which are mutually fitted to each other as shown in Figs. 11 to 13, and the spool 2 having the bonding wire 1 wound around it is stored in the spool case.

The spool 2 is provided with flanges 2b, 2c at both ends thereof. These flanges 2b, 2c are formed such that their diameters are in a range of 58.5 to 80 mm.

The spool case a" is comprised of a base 3 and a cover 4 which are mutually fitted to each other, wherein the base 3 and the cover 4 are made of plastic material or the like, they are moulded integrally by a vacuum molding method in a resilient deformable manner, the spool 2 having the bonding wire 1 wound therearound is held at the base 3 and the cover 4 is fitted to it from a side part.

The base 3 is provided with an outer circumferential ridge 5 fitted to an opening section edge 4a of the cover 4 at its outer circumferential section, and an expanded holding section 6 projected outwardly of the spool case a" is integrally arranged with the outer circumferential ridge 5 at the central section enclosed by the outer circumferential ridge 5.

In addition, the base 3 is provided with a plurality of engaging sections 7 for use in removably holding the spool 2.

A plurality of engaging sections 7 are arranged along the outer circumferential edge of the flange 2b for appropriate spacings at an inner surface 5a acting as a top surface of the outer circumferential ridge 5, i.e. the inner surface 5a abutted against the outer surface 2b' of the flange 2b of the spool 2 held at the base 3, the extremity end of each of the engaging sections is formed into a substantial claw-like or a substantial hook-like shape so as to be resiliently engaged with the outer circumferential edge of the flange 2b, each of the engaging sections 7 is engaged with the outer circumferential edge of the flange 2b to cause the flange 2b to be removably held, thereby the spool 2 is removably held at the base 3 in its canti-levered state.

Each of the engaging sections 7 is integrally formed with the outer surface 5a of the outer circumferential ridge 5, each of the engaging sections 7 is integrally and resiliently deformed with the outer circumferential ridge 5 and it is formed in such a way that its engaging or disengaging against the flange 2b (i.e. the engaging or disengaging of the spool 2) can be carried out.

In the present example, the right and left two engaging sections 7 are arranged to be corresponded to the right and left two locations at the outer circumferential edge of the flange 2b, the engaging section 7' not provided with the substantial claw-shape or substantial hook-shape section is abutted against the lower end of the outer circumferential edge of the flange 2b so as to enable the flange 2b to be supported and then the flange 2b is removably held by these three engaging sections, although the number or shape or installing positions of each of the engaging sections or the like is not limited to this, but a proper number of engaging sections removably engaged with the flange 2b, capable of holding the spool 2 and enabling its engaging or disengaging to be carried out can be arranged at appropriate locations.

A rib 8 is integrally arranged in correspondence with each of the engaging sections 7 at the outer surface of the outer circumferential ridge acting as a rear surface of the inner surface 5a, when the outer end edge 5b of the outer circumferential ridge is resiliently deformed inwardly, each of the engaging sections 7 is resiliently deformed in its opening section direction around a fulcrum point of this rib 8 and then the engaging or disengaging against the flange 2b may easily be carried out.

The inner surface 5a of the outer circumferential ridge 5 is provided with a plurality of appropriate releasing concave sections 9 corresponding to the projecting section of the spool holder 200 (for example, the engaging means 300 or the like) without producing any interference against the formation of the engaging sections 7 and in a range where strength, durability and resiliency required in the base 3 are maintained.

With such an arrangement as above, this is preferable due to the fact that when the spool 2 held at the base 3 is installed at the spool holder 200, the engaging means 300 are released into the concave sections 9 to facilitate its handling and then its applicability is improved.

In addition, the wider concave sections 9 are preferable. As the concave sections are wide, a positional alignment for the projecting sections (the engaging means 300 or the like) of the spool holder 200 is facilitated and an installing of the spool 2 against the spool holder 200 becomes more easy and at the same time its applicability in usage is further improved. In addition, a more simple shape of each of the concave sections 9 can prevent dust from being adhered and allows a washing of it to be easily carried out.

The lower surface of the outer circumferential ridge 5 is formed with a flat mounting surface 10a which is formed as a mounting means, and the mounting surface 10a and the mounting surface 10b of the cover 4 to be described later may form a mounting means capable of holding the spool 2 stored in the spool case a" under a lateral-directed state in which a central axis of the spool shows substantially a horizontal state.

The holding section 6 is formed such that a cylindrical surface is integrally formed outwardly from the inner end edge of the inner surface 5a of the outer circumferential ridge 5 to the spool case a", it may act as a handle when the base 3 is handled, and an accidental deformation of the engaging sections 7 can be prevented. That is, in the case that the holding section 6 is not provided, the outer circumferential ridge 5 may act as a holding section, although in this case, there may occur a possibility that as the outer circumferential ridge 5 is deformed accidentally, the engaging sections 7 are deformed and the spool 2 is dropped off. In view of this fact, the holding section 6 is provided as disclosed in the present example, and when the base 3 is handled, the holding section 6 is applied as a handling section, resulting in that an accidental deformation of the engaging sections 7 can be prevented.

The surface of the holding section 6 may form an anti-slipping section 6' by applying a mat finish (an anti-slipping processing) and its holding is made positive.

A space 11 inside the holding section 6 is corresponded to the inner side of the cylindrical barrel section 2a of the spool 2 held at the base 3 to act as a releasing section for the projecting part (the engaging means 300 or the like) of the spool holder 200.

In addition, the expanded end part of the holding section 6 is not closed, but formed as an opening section 12, wherein the opening section 12 is applied as a hole for releasing corresponded to the engaging means 300 of the spool holder 200 or the like.

In addition, the holding section 6 is formed as a substantial cone-pyramid shape with its outer diameter being gradually decreased from its projecting base end to the extremity end, the bases 3 can be closely overlapped from each other to reduce a cost when the bases 3 are stored and transported or the like.

The cover 4 is fitted to the outer circumferential ridge 5 of the base 3 to cover the spool 2, wherein its depth is formed to be substantially the same degree as a length of the spool 2 and then the flange 2c of the spool 2 is abutted against the side surface wall 4b.

A circumferential wall of the cover 4 is formed into a substantial semi-cylindrical form which can be fitted to the outer circumferential ridge 5 and at the same time its lower surface is formed with a flat mounting surface 10b so as to form the mounting means as described above.

The mounting means can hold the spool 2 while the central axis of the spool 2 is in a lateral directed state in a substantial horizontal direction when the spool case a" storing the spool 2 therein is placed on the working table or in a transporting case or the like, thereby the load of the wire 1 itself, vibration during its handling or transportation or the like or shock is distributed over an entire length of the wire 1 in a substantial uniform manner, resulting in that a collapsed winding of the wire 1 can be prevented effectively and further a rolling of the spool case a" may also be attained.

Within the cover 4 is arranged the expanded guiding ridge 13 loaded into the cylindrical barrel section 2a of the spool 2 to be held by the base 3, the spool 2 in the spool case a" is held at the base 3 in a canti-levered state and concurrently it is held at the cover 4 by the guiding ridge 13 to cause the holding of the spool 2 to be made positive.

In addition, the projecting end of the guiding ridge 13 is projected out of the opening section edge 4a of the cover 4 and when the base 3 and the cover 4 are fitted to each other, the guiding ridge 13 becomes a guide to feed the spool 2 toward the center of the cover 4 in such a way that the bonding wire 1 wound around the spool 2 held at the base 3 may not be contacted with the opening section edge 4a of the cover 4.

The guiding ridge 13 is formed such that its length (L') is set in a range more than 1/2 of a horizontal length (L) of the cover 4 and projecting only by an amount of 1/2 (L) from the opening section edge of the cover, thereby when the spool case a" is opened or closed, the bonding wire 1 wound around the spool 2 is guided in such a way that it is not contacted with the opening section edge 4a of the cover 4.

In addition, the guiding ridge 13 is made such that a portion projected from the cover opening section edge 4a is freely inserted into the inner space 11 of the holding section 6, and its projecting end 13a is fitted to the opening section 12 at the end of the holding section 6 so as to form the opening section 12 in such a way that it can be closed.

In addition, the guiding ridge 13 is formed into a substantial cone pyramid shape with its outer diameter being gradually decreased from its base end toward the extremity end, the covers 4 can be closely stucked up to reduce a cost when the covers 4 are stored and transported or the like.

The wire 1 wound around the cylindrical barrel section 2a of the spool 2 is set such that its winding finished end is stopped by a tape at the flange 2b, although in the present example, the outer circumferential ridge 5 of the base 3 is provided with the concave section 14 exposing the tape stopping end 1a.

The concave section 14 is arranged at the upper surface of the outer circumferential ridge 5 while being oppositely faced against the mounting surface 10a acting as the mounting means, the spool 2 is held by the base 3 to be exposed in such a way that the tape stopping end 1a is positioned within a range of opening section of the concave section 14, thereby the tape stopping end 1a of the spool 2 held at the base 3 can be peeled off without using any special tool such as tweezers.

In addition, since the tape stopping end 1a is exposed at the upper end of the base 3, the tape peeling-off operation can be adapted for both rightward operation and leftward operation.

15 in the figure denotes a pressing section formed in a concave shape at the side wall section 4b of the cover 4 so as to be abutted against the outer surface of the flange 2c of the spool 2 loaded into the guiding ridge 13. 16 denotes a pressing section projected at the outer circumference of the guiding ridge 13 so as to be abutted against the inner circumference of the cylindrical barrel section 2a of the spool 2. The pressing section 15 prevents an axial looseness of the spool 2 and the pressing section 16 prevents a looseness of the spool 12 in a direction toward the diameter.

In view of the foregoing, this kind of spool case is recovered after its use, it is passed through inspection, cleaning and drying operations and repeatedly used, although in the present example, the locations of all the corners in the aforesaid base 3, the cover 4, for example, the corners at the concave portions of the releasing concave portion 9, concave portion 14 and pressing sections 15, 16 or the like and the cooperative corners between the inner surface 5a at the outer circumferential ridge 5 and the holding section 6 are formed as curved surfaces having a R more more, a water splashing action at the drying step after cleaning can be performed rapidly and positively.

In addition, in the present example, an order of taking out the spool 2 stored in the spool case a" is displayed at a proper location of the spool case a".

That is, the holding section 6 in the base 3 and each of the outer ends of the cover 4 are provided with outward-directed arrows 17, 18 for acknowledging a separation of the base 3 and the cover 4 to be fitted to each other, and a triangular symbol 19 for acknowledging a pressing location for performing a resilient deformation of the outer end edge 5b in an inward direction, deforming the engaging section 7 and removing the spool 2 is arranged near the engaging section 7 of the outer circumferential ridge 5. In addition, the arrows 17, 18 and the symbol 19 are provided with numerals 20, 21, 22.

The spool case of the present example constructed as described above is made such that each of the engaging sections 7 of the inner surface 5a of the outer circumferential ridge 5 in the base 3 is resiliently engaged with the outer circumferential edge of the flange 2b of the spool 2 around which the bonding wire 1 is wound, the spool 2 is held at the base 3, the base 3 and the cover 4 are fitted to each other while the guiding ridge 13 is being inserted into the cylindrical barrel section 2a of the spool 2 and then the spool 2 can be stored in the spool case a".

In this way, the spool case a" is handled in such a way that the mounting surfaces 10a, 10b are faced down, the stored spool 2 is held in such a way that its central axis may become substantially a horizontal orientation so as to prevent a collapsing of winding of the wound bonding wire 1.

In addition, after the base 3 and the cover 4 are separated from each other to open the spool case a", the base 3 having the spool 2 held therein is handled to enable the engaging or disengaging of the spool 2 to be carried out without performing any direct contact of the spool with hand.

That is, the held spool 2 is maintained by the resilient engaging force of each of the engaging sections 7, this held state is not released so long as these engaging sections 7 are resiliently deformed and released from the flange 2b. In addition, the held state holds it by engaging each of the engaging sections 7 to the outer circumferential edge of the flange 2b, wherein there occurs no interference against the wire 1 wound around the spool cylindrical barrel section 2a or the inside part of the cylindrical barrel section 2a.

For example, in the case that the spool 2 is installed at the spool holder 200, the holding section 6 is held to cover the base 3 on the holder 200, the spool 2 is outwardly fitted to the holder 200, and if the outer end edge 5b of the outer circumferential ridge 5 is deformed inwardly, each of the engaging sections 7 is integrally and resiliently deformed to release the engaged state of the flange 2b, thereafter when only the base 3 is released, the spool 2 is installed at the holder 200 (refer to Fig. 16).

During this operation, it is possible to release the spool engaging means 300 accompanied by the holder 200 into the concave sections 9, space 11 and the opening section 12 or the like, resulting in that the engaging means 300 does not interfere with the spool installing operation.

When the spool 2 is removed from the holder 200, it is satisfactory that the aforesaid operation is carried out and then the spool 2 is held by the base 3.

With the foregoing, although several preferred embodiments of the present invention have been described, the present invention is not restricted to these preferred embodiments and other different preferred embodiments can be attained if they are within the scope of the present invention as defined in the appended claims.

For example, Fig. 17 shows an arrangement in which the aforesaid mounting surfaces 10a, 10b are not formed, but the lower end surface of the spool case a" is applied as a slant surface and in turn the lower end surface is provided with a leg 23 for holding the spool 2 in such a way that its central axis may become horizontal so as to form the mounting means.

In addition, if the leg 23 is formed to be foldable, it is preferable that the base 3 and the cover 4 can be closely stucked up to each other.

In addition, if any one of or both of the base and the cover are made transparent, it is preferable that the type and the standards of the wire 1 wound around the spool 2 can be acknowledged.

For a sake of convenience in illustration, although the bonding wire 1 is shown in a larger diameter than that of the actual wire and a single layer winding is applied to the spool 2, it is apparent that the wire 1 is a fine wire with a diameter of less than 1 mm, the wire is wound in multi-layer around the spool 2 and the extremity end of the engaging section 7 is formed in such a size as one in which it may not be contacted with the surface layer of the wire 1 wound around in multi-layer.

The effects of the present invention are as follows.

The engaging piece arranged at the base or the cover is engaged with the outer circumferential edge of the flange to enable the spool to be held at either the base or the cover.

Accordingly, the spool can be replaced with another one without damaging the wire or the like under a direct contact of the surface of the wire with hand and there is provided a general applicability that the accommodation for various kinds of bonding devices can be attained without being influenced by a length of the spool holder or the spool engaging means or the like.

In addition, since the flange held condition is maintained by the engaging pieces, the present invention may provide an effect that even if the operator hands off the device, a high reliable handling in operation can be realized.

It can be expected in the present invention that a positive characteristic in holding the spool described above and an operability in deforming the engaging piece to release the held condition can be improved.

In the case that the engaging piece is arranged in either the base or at the inner surface of the cover, it is possible to store the spool in the spool case under a state in which the spool is held at the base or the cover and it can contribute to an improvement of prevention of the looseness in the spool.

In the case that the engaging piece is integrally and resiliently deformed with either the base or the cover, the base or the cover is operated, resulting in that each of the engaging pieces is integrally and resiliently deformed to enable a fixing or a removing of the spool to be carried out and then a workability in operation can be improved more.

In the case that the spool is held in a lateral directed state in such a way that its central axis may become substantially a horizontal orientation, a load of the wire itself, vibration or shock during handling of or transportation of the wire itself are dispersed in a substantial uniform manner over an entire length of the wire which is wound around the spool, resulting in that a collapsing of wound wire can be effectively prevented.

A spool with its diameter of either one of or both end flanges being in a range of 58.5 to 80 mm may be processed and the engaging pieces are formed in such a way that they may be resiliently engaged with the outer circumferential edge of the flange, so that for example, it is possible to accommodate for various kinds of spools like the spool having both flanges with same diameter from each other or the spool having one flange with a larger diameter than that of the other flange. In particular, in the case that the spool with one flange having a larger diameter than that of the other flange is processed, the present invention hay have a more superior effect under a mutual multiplication of one advantage provided in the spool itself and the other advantage in which the flange of larger diameter is held to handle the spool and the contact with the bonding wire wound around the spool can be reduced even if a winding amount is increased to attain a wound fat state.

In the case that the spool is guided by a guiding ridge arranged in the cover when the spool case is opened or closed, the bonding wire wound around the spool is not contacted with the opening section edge of the cover and the spool can be handled.

### [Claim 9]

If the spool case of the present invention is used, the present invention can be used preferably in this kind of technical field as a handling method in which the spool can be handled without making a direct contact with the spool by hand.

Having described specific preferred embodiments of the invention with reference to the accompanying drawings, it will be appreciated that the present invention is not limited to those precise embodiments, and that various changes and modifications can be effected therein by one of ordinary skill in the art without departing from the scope of the invention as defined by the appended claims.

## Claims

1. A spool case (a, a', a'') for storing within the spool case a spool (100) for winding up a bonding wire (110) said spool case comprised of a base (1, 1', 3) and a cover (2, 2', 4) to be fitted to each other, **characterized in that** at least one of the base and the cover is provided with at least one engaging piece (5, 7) for removably engaging with the outer circumferential edge of the flange (102) of said spool so as to hold said spool within said spool case.

2. A spool case according to Claim 1, wherein a plurality of said engaging pieces are provided.

3. A spool case (a') according to Claim 1, wherein at least one further engaging piece (11) is arranged at the outside part of the base.

4. A spool case according to Claim 1, wherein either the base or the cover provided with said engaging pieces is designed in such a way that it may be resiliently deformed, and the engaging pieces are integrally and resiliently deformable with said base or cover to enable an engaging or disengaging of the spool to be carried out.

5. A spool case according to Claim 1, wherein the spool case is formed in such a way that the stored spool can be held in a lateral oriented state with its central axis being substantially horizontal.

6. A spool case (a") according to Claim 1, wherein said base (3) has an outer circumferential ridge (5) for fitting to said cover the inner surface of said outer circumferential ridge being provided with a plurality of engaging pieces (7) for resiliently engaging with the outer circumferential edge of the flange of a spool (100) when stored in the spool case, each of the engaging sections being integrally and resiliently deformable with said base for holding the spool removably, said cover being provided with an expanded guiding ridge (13) for loading into the barrel section (2a) of the spool, said guiding ridge being formed to guide the spool when the spool case is opened or closed.

7. A spool case according to Claim 1 in combination with a spool (100) having the bonding wire wound therearound stored in the spool case.

8. A spool case in combination with a spool as defined in claim 7 wherein either one or both of the end flanges of the spool has a diameter of 58.5 to 80 mm, and wherein the engaging pieces are formed to be resiliently engaged with the outer circumferential edge of said one or both of the flanges.

9. A method for handling a spool using a spool case according to Claim 1, wherein the spool is held at either the base or the cover by said engaging pieces (7, 5) and said spool is handled without making any direct contact with the spool by hand.

## Patentansprüche

1. Spindelbehälter (a, a', a"), um eine Spindel (100) zum Aufwickeln eines Bonddrahtes (11) in dem Spindelbehälter lagernd aufzunehmen, wobei sich der genannte Spindelbehälter aus einem Basisteil (1, 1', 3) und einem Deckelteil (2, 2', 4) zusammensetzt, die aneinander montiert werden, **dadurch gekennzeichnet, dass** das Basisteil und/oder das Deckelteil mit wenigstens einem Eingriffsteil (5, 7) versehen ist, um lösbar in den äußeren Umfangsrand des Flansches (102) der genannten Spindel einzugreifen, um die genannte Spindel in dem genannten Spindelbehälter zu halten.

2. Spindelbehälter nach Anspruch 1, wobei eine Mehrzahl der genannten Eingriffsteile vorgesehen ist.

3. Spindelbehälter (a') nach Anspruch 1, wobei wenigstens ein weiteres Eingriffsteil (11) am Außenteil des Basisteils angeordnet ist.

4. Spindelbehälter nach Anspruch 1, wobei entweder das Basisteil oder das Deckelteil, das mit den genannten Eingriffsteilen versehen ist, so ausgelegt ist, dass es sich elastisch verformen kann, und die Eingriffsteile einstückig und elastisch mit dem genannten Basisoder Deckelteil verformbar sind, so dass sie mit der Spindel in Eingriff gebracht oder aus dem Eingriff damit gelöst werden können.

5. Spindelbehälter nach Anspruch 1, wobei der Spindelbehälter so ausgebildet ist, dass die lagernd aufgenommene Spindel in einem seitlich ausgerichteten Zustand gehalten werden kann, in dem ihre Mittelachse im Wesentlichen horizontal ist.

6. Spindelbehälter (a") nach Anspruch 1, bei dem das genannte Basisteil (3) eine äußere Umfangsrippe (5) für eine Montage an dem genannten Deckelteil hat, wobei die Innenfläche der genannten äußeren Umfangsrippe mit einer Mehrzahl von Eingriffsteilen (7) für einen elastischen Eingriff mit dem äußeren Umfangsrand des Flansches einer Spindel (100) versehen ist, wenn diese lagernd im Spindelbehälter aufgenommen ist, wobei jeder der Eingriffsabschnitte einstückig und elastisch mit dem genannten Basisteil verformbar ist, um die Spindel lösbar zu halten, wobei das genannte Deckelteil mit einer erweiterten Führungsrippe (13) zum Laden der Spindel in den Trommelabschnitt (2a) versehen ist, wobei die genannte Führungsrippe so gestaltet ist, dass sie die Spindel führt, wenn der Spindelbehälter geöffnet oder geschlossen wird.

7. Spindelbehälter nach Anspruch 1 in Kombination mit einer Spindel (100), wobei der darum gewickelte Bonddraht in dem Spindelbehälter lagernd aufgenommen ist.

8. Spindelbehälter in Kombination mit einer Spindel gemäß Definition in Anspruch 7, wobei entweder ein oder beide Endflansch(e) der Spindel einen Durchmesser von 58,5 bis 80 mm hat/haben, und wobei die Eingriffsteile so gestaltet sind, dass sie mit dem äußeren Umfangsrand des/der genannten einen oder beider Flansche(s) elastisch eingreifen können.

9. Verfahren zum Handhaben einer Spindel unter Verwendung eines Spindelbehälters nach Anspruch 1, wobei die Spindel entweder am Basisteil oder am Deckelteil von den genannten Eingriffsteilen (7, 5) gehalten wird, und die genannte Spindel gehandhabt wird, ohne dass ein direkter Kontakt der Spindel mit der Hand zustande kommt.

## Revendications

1. Boîtier pour bobine (a, a', a") servant à ranger, à l'intérieur du boîtier pour bobine, une bobine (100) pour enrouler un fil de connexion (110), ledit boîtier pour bobine étant constitué d'une base (1, 1', 3) et d'un couvercle (2, 2', 4) qui sont destinés à être montés l'un sur l'autre, **caractérisé en ce que** l'un des postes au moins, soit la base, soit le couvercle, est pourvu d'une pièce d'engagement (5, 7) au moins pour s'engager de façon détachable avec le bord circonférentiel externe de la bride (102) de ladite bobine afin de maintenir ladite bobine à l'intérieur dudit boîtier pour bobine.

2. Boîtier pour bobine, selon la revendication 1, dans lequel une pluralité desdites pièces d'engagement est prévue.

3. Boîtier pour bobine (a'), selon la revendication 1, dans lequel une autre pièce d'engagement (11) au moins est agencée au niveau de la partie externe de la base.

4. Boîtier pour bobine, selon la revendication 1, dans lequel soit la base soit le couvercle muni desdites pièces d'engagement est conçu de manière à ce qu'il puisse être déformé de façon élastique, et les pièces d'engagement sont déformables de façon élastique et intégrée avec ladite base ou ledit couvercle pour permettre d'effectuer l'engagement ou le désengagement de la bobine.

5. Boîtier pour bobine, selon la revendication 1, dans lequel le boîtier pour bobine est fabriqué de manière à ce que la bobine rangée puisse être maintenue dans un état orienté latéralement alors que son axe central est essentiellement horizontal.

6. Boîtier pour bobine (a"), selon la revendication 1, dans lequel ladite base (3) possède une arête circonférentielle externe (5) destinée à être montée sur ledit couvercle, la surface interne de ladite arête circonférentielle externe étant pourvue d'une pluralité de pièces d'engagement (7) capables de s'engager de façon élastique avec le bord circonférentiel externe de la bride d'une bobine (100) lorsqu'elle est rangée dans le boîtier pour bobine, chacune des sections d'engagement étant déformable de façon élastique et intégrée avec ladite base afin de retenir la bobine de façon détachable, ledit couvercle étant pourvu d'une arête de guidage élargie (13) pour permettre le chargement dans la section tambour (20) de la bobine, ladite arête de guidage étant fabriquée pour guider la bobine lorsque le boîtier pour bobine est ouvert ou fermé.

7. Boîtier pour bobine selon la revendication 1, en combinaison avec une bobine (100) autour de laquelle est enroulé le fil de connexion et qui est rangée dans le boîtier pour bobine.

8. Boîtier pour bobine en combinaison avec une bobine, tel qu'il est défini à la revendication 7, dans lequel soit l'une des brides d'extrémité de la bobine, soit les deux brides, a (ont) un diamètre de 58,5 à 80 mm, et dans lequel les pièces d'engagement sont fabriquées de façon à ce qu'elles puissent être engagées de façon élastique avec le bord circonférentiel externe de l'une desdites brides, ou desdites deux brides.

9. Procédé servant à manipuler une bobine faisant intervenir un boîtier pour bobine, selon la revendication 1, dans lequel la bobine est maintenue soit au niveau de la base soit au niveau du couvercle par lesdites pièces d'engagement (7, 5) et ladite bobine est manipulée sans que la main n'entre directement en contact avec la bobine.
